# EUROPEAN PATENT SPECIFICATION

(11) **EP 0 870 397 B1**
(45) Date of publication and mention of the grant of the patent: **27.11.2002**
(21) Application number: 97915648.6
(22) Date of filing: 23.04.1997
(51) Int. Cl.: H04N 3/20, H04N 5/63, H02H 9/04

(54) **OVER-CURRENT PROTECTION CIRCUIT IN LINE DEFLECTION CIRCUITS**
ÜBERSTROMSCHUTZSCHALTUNG FÜR EINE ZEILENABLENKSCHALTUNG
CIRCUIT DE PROTECTION CONTRE LES SURINTENSITES DANS DES CIRCUITS DE DEVIATION DE LIGNE

(30) Priority: 01.07.1996 US 673996
(43) Date of publication of application: 14.10.1998
(73) Proprietor: Koninklijke Philips Electronics N.V., 5621 BA Eindhoven (NL)
(72) Inventor: JENNINGS, James, R., NL-5656 AA Eindhoven (NL)
(74) Representative: Groenendaal, Antonius Wilhelmus Maria
(86) International application number: PCT/IB97/00427
(87) International publication number: WO 98/000967

(56) References cited:
- WO-A-91/10317
- US-A- 3 916 288
- US-A- 4 213 166
- US-A- 4 459 517
- US-A- 4 595 977
- US-A- 4 885 509
- US-A- 5 119 262

## Description

The subject invention relates to line deflection circuits in television receivers.

In a typical cathode ray tube (CRT) television receiver, a high voltage supply derived from an AC line is used to provide a DC collector supply voltage for a horizontal deflection output transistor. The collector supply voltage is coupled through a primary of a flyback transformer to the horizontal output transistor. As is well known, the horizontal output transistor is used to supply an alternating current to the primary of the flyback transformer. This current, in turn, induces a relatively high voltage in a flyback secondary from which is derived the anode voltage for the CRT. Additionally, a horizontal deflection coil in series with a capacitor is connected to the collector of the horizontal output transistor.

The base of the horizontal output transistor is coupled through a resistor to the secondary winding of a drive transformer. The primary winding of the drive transformer connects the above-noted DC collector supply voltage to the collector of a horizontal drive transistor. The base of the horizontal drive transistor then receives horizontal signals from the horizontal oscillator.

Ordinarily, the horizontal output transistor is dimensioned such that it operates in saturation. However, situations arise causing the horizontal output transistor to exceed its safe operating area (SOA). These situations, which may include normal start-up of the television receiver, RF interference, CRT arcing, and lightning transients, cause the normally occurring drive pulses from the horizontal drive transistor to be interrupted. The missing drive pulses cause the horizontal output transistor to turn on longer than normal thus causing a large current to flow through the horizontal output transistor. The flyback transformer eventually saturates causing an even greater increase in the transistor current. The horizontal output transistor does not have enough base drive to handle the large collector current so it pulls out of saturation. The collector-emitter voltage developed across the horizontal output transistor at this time may now exceed the SOA of the transistor and as such, failure may result.

U.S. Patent 4,185,234 discloses an isolated DC collector supply voltage sensing and high-voltage shutdown circuit which detects when the DC collector supply voltage exceeds a predetermined level and then stops operation of the horizontal deflection circuit by effectively short circuiting the output from the horizontal oscillator thereby terminating the drive signal for the horizontal drive transistor. While this circuit will stop the operation of the horizontal deflection circuit, it will not detect the over-current conditions on the horizontal output transistor which result from situations other than an over-voltage condition on the high voltage line.

U.S. Patent 4,885,509 discloses a protection circuit which shuts off a power to be supplied to the horizontal drive circuit when a current in the primary side of the flyback transformer becomes large in reference to a current in the secondary side of the flyback transformer. By shutting off the power of the horizontal driver circuit the line deflection is stopped to prevent overheat generation of the flyback transformer.

This protection will not detect an instantaneous over-current through the line output transistor which could occur before the disclosed protection stops the line deflection. Moreover after the power has been shut off it remains off permanently, so a service technician is needed to restore the apparatus.

It is an object of the present invention to prevent the line output transistor from failure due to over-current. To this end a first aspect of the invention provides a line deflection circuit as defined in claim 1. A second aspect provides a display apparatus as defined in claim 8. Advantageous embodiments are defined in the dependent claims.

In a preferred embodiment of the invention, the detecting means includes a resistor arranged between the second main terminal of the line output transistor and the reference terminal, and the interrupting means includes a silicon controlled rectifier (SCR) connecting the first main terminal of the line drive transistor to the reference terminal. The control electrode of the SCR is coupled to the second main terminal of the line output transistor.

In the above circuit, when the current sensed through the resistor gets to such a level that the voltage across the resistor exceeds the gate threshold voltage of the SCR, the SCR will turn on thus removing a drive pulse to the line output transistor, thereby turning it off. On the arrival of a next line drive pulse, the line drive transistor is turned on which removes the latch current from the SCR, thereby turning the SCR off and thus resetting the circuit.

Applicant has found that the point were the drive pulse is removed can be anywhere in the line drive path, even at the control terminal of the line output transistor. The present location is preferred due to low currents less susceptibility to CRT arc currents that may be present at the control terminal of the line output transistor.

With the above and additional objects and advantages in mind as will hereinafter appear, the invention will be described with reference to the accompanying drawings, in which:
Fig. 1 shows a schematic diagram of a portion of a known horizontal deflection circuit; and
Fig. 2 shows a schematic diagram of a line deflection circuit incorporating the protection circuit of the subject invention.

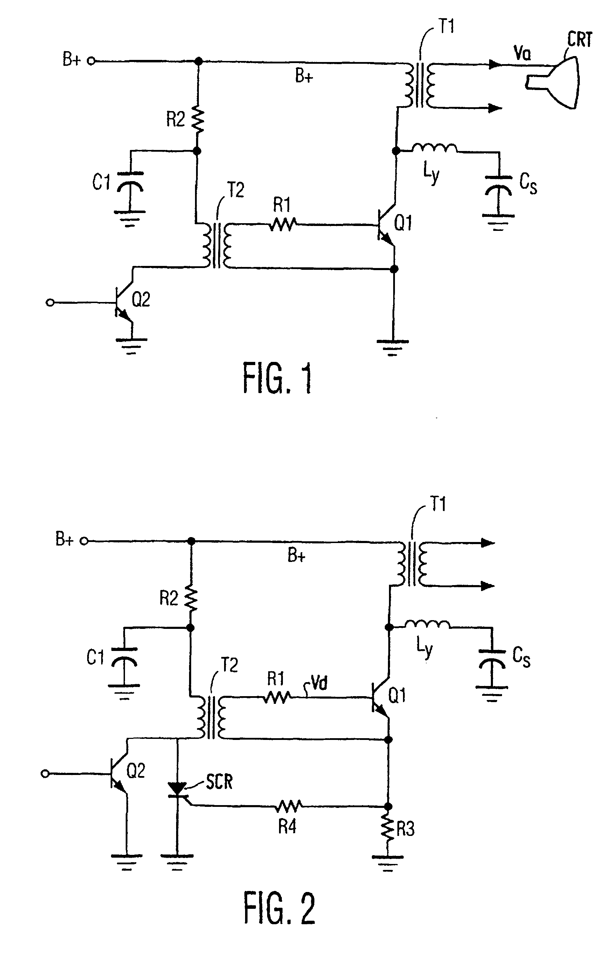

Fig. 1 shows a schematic diagram of a portion of a known line deflection circuit.

In a typical cathode ray tube (CRT) television receiver, a high voltage supply derived from an AC line is used to provide a DC collector supply voltage B+ for a horizontal deflection output transistor Q1. The collector supply voltage B+ is coupled through a primary of a flyback transformer T1 to the horizontal output transistor Q1. As is well known, the horizontal output transistor is used to supply an alternating current to the primary of the flyback transformer T1. This current, in turn, induces a relatively high voltage in a flyback secondary from which is derived the anode voltage Va for the CRT. Additionally, a horizontal deflection coil Ly in series with a capacitor Cs is connected to the collector of the horizontal output transistor Q1.

The base of the horizontal output transistor Q1 is coupled through a resistor R1 to the secondary winding of a drive transformer T2. The primary winding of the drive transformer T2 connects the above-noted DC collector supply voltage B+ to the collector of a horizontal drive transistor Q2. The base of the horizontal drive transistor Q2 then receives horizontal signals from the horizontal oscillator.

Fig. 2 shows a portion of line deflection circuit substantially similar to that shown in Fig. 1. In addition, a resistor R3 is inserted between the junction point of the secondary of the line drive transformer T2 and the emitter of the line output transistor Q1 and ground. This resistor R3 then forms detecting means for detecting the current through the collector-emitter path of the line output transistor Q1.

A silicon controlled rectifier SCR is connected between the collector of the line drive transistor Q2 and ground. The control electrode of the SCR is connected, through resistor R4, to the above-noted junction point.

In operation, the current through the resistor R3 causes a voltage to appear across the resistor R3. When this voltage exceeds the gate threshold of the SCR (approx. 0.6 volts), the SCR is turned on thereby short circuiting the drive signal from the line drive transistor Q2 to primary winding of the line drive transformer T2. This removes the drive signal Vd to the base of the line output transistor Q1 thereby shutting it off. While the turning off of the line output transistor Q1 interrupts the current and eliminates the voltage drop across resistor R3, the SCR remains latched due to the current passing through it from the primary winding of the line drive transformer T2. Upon the occurrence of a next line drive pulse on the base of the line drive transistor Q2, this current is drained allowing the SCR to turn off thereby resetting the protection circuit.

Applicant has found that the value of resistor R3 should be approximately 0.075 ohms, with this value being adjustable to determine the "trip point" of the protection circuit. The resistor R4 (approx. 47 ohms) is used to control the sensitivity of the SCR. The low resistance from the gate to cathode results in dv/dt desensitization, anode to gate leakage current desensitization, and greater noise immunity.

With regard to capacitor C1, while in prior art line deflection circuits the value of C1 is usually 1 µF, Applicant has found it necessary to reduce this value to 0.22 µF to allow for a quicker start-up after the SCR unlatches which results in good line drive during restart.

Numerous alterations and modifications of the structure herein disclosed will present themselves to those skilled in the art. However, it is to be understood that the above described embodiment is for purposes of illustration only and not to be construed as a limitation of the invention.

The line deflection circuit can be used to deflect the lines in the horizontal direction, whereby the lines succeed each other in the vertical direction, as is common practice in display apparatus for display of text or pictures.

The line deflection circuit can also be used to deflect the lines in vertical direction, whereby the lines succeed each other in the horizontal direction as is the case in the so called transposed scan systems.

Instead of the bipolar horizontal output transistor Q1 also a field effect transistor or any other suitable controllable switching device may be used. The controllable switching device Q1 comprises a first main terminal and a second main terminal for forming a main current path and a control terminal to influence the main current path. If the controllable switching device is a NPN bipolar transistor the first main terminal is the collector, the second main terminal in the emitter and the bipolar transistor instead of the bipolar horizontal drive transistor Q2 also a field effect transistor may be used. The horizontal drive transistor comprises a first main terminal, a second main terminal and a control terminal for controlling a current which flows in a main current path which is arranged between the first and the second main terminal. If the horizontal drive transistor Q1 is a bipolar transistor, the first main terminal is the collector, the second main terminal is the emitter and the control terminal is the base of the bipolar drive transistor Q1.

The reference terminal is preferably connected to ground.

## Claims

1. A line deflection circuit comprising:
a flyback transformer (T1) having a primary winding and a secondary winding, said secondary winding providing an anode voltage (Va) for a cathode ray tube (CRT);
means for supplying a D.C. voltage (B⁺) to a first end of the primary winding of said flyback transformer (T1);
a line output transistor (Q1) having a first main terminal coupled to a second end of the primary winding of the flyback transformer (T1), a second main terminal coupled to a reference terminal, and a control terminal for controlling a current flowing in a main current path being arranged between the first and the second main terminal,
a drive transformer (T2) having a primary winding and a secondary winding, said secondary winding having a first end coupled to the control terminal of the line output transistor (Q1) and a second end coupled to the second main terminal of said line output transistor (Q1), and said primary winding having a first end also coupled to said supplying means;
a line drive transistor (Q2) having a first main terminal coupled to a second end of the primary winding of said drive transformer (T2), a second main terminal coupled to the reference terminal, and a control terminal;
means for providing a line drive signal coupled to the control terminal of said line drive transistor;
detecting means (R3) for detecting the current through the main current path of said line output transistor (Q1); and
interrupting means (SCR), coupled to said detecting means, for interrupting a drive current to the control terminal of said line output transistor (Q1) when the current in the main current path exceeds a predetermined level,
**characterized in that** said interrupting means (SCR) comprises a controllable switch coupling a path between said first main terminal of said line drive transistor (Q2) and said control terminal of said line output transistor (Q1) to the reference terminal, a control input of said controllable switch (SCR) being connected to said detecting means (R3).

2. A line deflection circuit as claimed in claim 1, wherein said detecting means comprises a resistor (R3) coupled between the second main terminal of said line output transistor (Q1) and the reference terminal.

3. A line deflection circuit as claimed in claim 2, wherein said controllable switch (SCR) couples the first main terminal of said line drive transistor (Q2) to the reference terminal.

4. A line deflection circuit as claimed in claim 2, wherein said controllable switch (SCR) couples the secondary winding of said drive transformer (T2) to the reference terminal.

5. A line deflection circuit as claimed in claim 2, wherein said controllable switch (SCR) comprises a silicon controlled rectifier (SCR).

6. A line deflection circuit as claimed in claim 5, wherein said detecting means comprises a resistor (R3) coupled between the second main terminal of said line output transistor (Q1) and the reference terminal, and a control input of said SCR is coupled to the second main terminal of said line output transistor (Q1).

7. A line deflection circuit as claimed in claim 6, wherein said interrupting means further comprises a resistor (R4) connecting the control input of said SCR to the second main terminal of the line output transistor (Q1).

8. A display apparatus comprising:
a cathode ray tube (CRT) with a line deflection coil, and
a line deflection circuit comprising:
a flyback transformer (T1) having a primary winding and a secondary winding, said secondary winding providing an anode voltage (Va) for said cathode ray tube;
means for supplying a D.C. voltage (B⁺) to a first end of the primary winding of said flyback transformer (T1);
a line output transistor (Q1) having a first main terminal coupled to a second end of the primary winding of the flyback transformer (T1), a second main terminal coupled to a reference terminal, and a control terminal for controlling a current flowing in a main current path being arranged between the first and the second main terminal,
a drive transformer (T2) having a primary winding and a secondary winding, said secondary winding having a first end coupled to the control terminal of the line output transistor (Q1) and a second end coupled to the second main terminal of said line output transistor (Q1), and said primary winding having a first end also coupled to said supplying means (B⁺);
a line drive transistor (Q2) having a first main terminal coupled to a second end of the primary winding of said drive transformer (T2), a second main terminal coupled to the reference terminal, and a control terminal;
means for providing a line drive signal coupled to the control terminal of said line drive transistor (Q2);
detecting means (R3) for detecting the current through the main current path of said line output transistor (Q1); and
interrupting means (SCR), coupled to said detecting means (R3), for interrupting a drive current to the control terminal of said line output transistor (Q1) when the current in the main current path exceeds a predetermined level, **characterized in that** said interrupting means (SCR) comprises a controllable switch coupling a path between said first main terminal of said line drive transistor (Q2) and said control terminal of said line output transistor (Q1) to the reference terminal, a control input of said controllable switch (SCR) being connected to said detecting means (R3).

## Patentansprüche

1. Zeilenablenkschaltung, welche die nachfolgenden Elemente umfasst:
- einen Horizontal-Ablenktransformator (T1) mit einer Primärwicklung und einer Sekundärwicklung, wobei die genannte Sekundärwicklung eine Anodenspannung (Va) für die Elektronenstrahlröhre (CRT) schafft;
- Mittel zum Liefern einer DC-Spannung (B⁺) zu einem ersten Ende der Primärwicklung des genannten Horizontal-Ablenktransformators (T1);
- einen Zeilenausgangstransistor (Q1) mit einer ersten Hauptklemme, die mit einem zweiten Ende der Primärwicklung des Horizontal-Ablenktransformators (T1) gekoppelt ist, wobei eine zweite Hauptklemme mit einer Bezugsklemme gekoppelt ist und wobei eine Steuerklemme zur Steuerung eines Stromes, der in einer Hauptstromstrekke fließt, zwischen der ersten und der zweiten Hauptklemme vorgesehen ist,
- einen Treibertransformator (T2) mit einer Primärwicklung und einer Sekundärwicklung, wobei ein erstes Ende der genannten Sekundärwicklung mit der Steuerklemme des Zeilenausgangstransistors (Q1) gekoppelt ist, und wobei ein erstes Ende der genannten Primärwicklung ebenfalls mit den genannten Speisemitteln gekoppelt ist;
- einen Zeilentreibertransistor (Q2), mit einer ersten Hauptklemme, die mit einem zweiten Ende der Primärwicklung des genannten Treibertransformators (T2) gekoppelt ist, mit einer zweiten Hauptklemme, die mit der Bezugsklemme gekoppelt ist, und mit einer Steuerklemme;
- Mittel zum Liefern eines Zeilentreibersignals, das mit der Steuerklemme des genannten Zeilentreibertransistors gekoppelt ist;
- Detektionsmittel (R3) zum Detektieren des Stromes durch die Hauptstromstrecke des genannten Zeilenausgangstransistors (Q1); und
- Unterbrechungsmittel (SCR), die mit den genannten Detektionsmitteln gekoppelt sind, zum Unterbrechen eines Treiberstromes zu der Steuerklemme des genannten Zeilenausgangstransistors (Q1), wenn der Strom in der Hauptstromstrecke einen vorbestimmten Pegel übersteigt,
**dadurch gekennzeichnet, dass** die genannten Unterbrechungsmittel (SCR) einen steuerbaren Schalter aufweisen, der eine Strecke zwischen der genannten ersten Hauptklemme des genannten Treibertransistors (Q2) und der genannten Steuerklemme des genannten Zeilenausgangstransistors (Q1) mit der Bezugsklemme koppelt, wobei ein Steuereingang des genannten steuerbaren Schalters (SCR) mit den genannten Detektionsmitteln (R3) verbunden ist.

2. Zeilenablenkschaltung nach Anspruch 1, wobei die genannten Detektionsmittel einen Widerstand (R3) umfassen, der zwischen der genannten zweiten Hauptklemme des genannten Zeilenausgangstransistors (Q1) und der Bezugsklemme gekoppelt ist.

3. Zeilenablenkschaltung nach Anspruch 2, wobei der genannte steuerbare Schalter (SCR) die erste Hauptklemme des genannten Zeilentreibertransistors (Q2) mit der Bezugsklemme koppelt.

4. Zeilenablenkschaltung nach Anspruch 2, wobei der genannte steuerbare Schalter (SCR) die Sekundärwicklung des genannten Treibertransformators (T2) mit der Bezugsquelle koppelt.

5. Zeilenablenkschaltung nach Anspruch 2, wobei der genannte steuerbare Schalter (SCR) einen steuerbaren Siliziumgleichrichter (SCR) umfasst.

6. Zeilenablenkschaltung nach Anspruch 5, wobei die genannten Detektionsmittel einen Widerstand (R3) umfassen, der zwischen der genannten Hauptklemme des genannten Zeilenausgangstransistors (Q1) und der Bezugsquelle vorgesehen ist, und wobei ein Steuereingang des genannten SCRs mit der zweiten Hauptklemme des genannten Zeilenausgangstransistors (Q1) gekoppelt ist.

7. Zeilenablenkschaltung nach Anspruch 6, wobei die genannten Unterbrechungsmittel weiterhin einen Widerstand (R4) umfassen, der den Steuereingang des genannten SCRs mit der zweiten Hauptklemme des Zeilenausgangstransistors (Q1) verbindet.

8. Wiedergabeanordnung, welche die nachfolgenden Elemente umfasst:
- eine Elektronenstrahlröhre (CRT) mit einer Zeilenablenkspule, und
- eine Zeilenablenkschaltung, welche die nachfolgenden Elemente umfasst:
- einen Horizontal-Ablenktransformator (T1) mit einer Primarwicklung und einer Sekundärwicklung,
wobei die genannte Sekundärwicklung eine Anodenspannung (Va) für die Elektronenstrahlröhre schafft;
- Mittel zum Liefern einer DC-Spannung (B⁺) zu einem ersten Ende der Primärwicklung des genannten Horizontal-Ablenktransformators (T1);
- einen Zeilenausgangstransistor (Q1), von dem eine erste Hauptklemme mit einem zweiten Ende der Primärwicklung des Horizontal-Ablenktransformators (T1) gekoppelt ist, von dem eine zweite Hauptklemme mit einer Bezugsklemme gekoppelt ist, und wobei eine Steuerklemme zur Steuerung eines Stromes, der in einer Hauptstromstrecke fließt, zwischen der ersten und der zweiten Hauptklemme vorgesehen ist,
- wobei ein Treibertransformator (T2) eine Primärwicklung und eine Sekundärwicklung hat, wobei von der genannten Sekundärwicklung ein erstes Ende mit der Steuerklemme des Zeilenausgangstransistors (Q1) gekoppelt ist und ein zweites Ende mit der zweiten Hauptklemme des genannten Zeilenausgangstransistors (Q1) gekoppelt ist, und wobei von der genannten Primärwicklung ein erstes Ende ebenfalls mit den genannten Speisemitteln (B⁺) gekoppelt ist;
- einen Zeilentreibertransistor (Q2), von dem eine erste Hauptklemme mit einem zweiten Ende der Primärwicklung des genannten Treibertransistors (T2) gekoppelt ist, eine zweite Hauptklemme mit der Bezugsklemme sowie mit einer Steuerklemme gekoppelt ist,
- Mittel zum Liefern eines Zeilentreibersignals, die mit der Steuerklemme des genannten Zeilentreibertransistors (Q2) gekoppelt ist;
- Detektionsmittel (R3) zum Detektieren des Stromes durch die Hauptstromstrecke des genannten Zeilenausgangstransistors (Q1), und
- Unterbrechungsmittel (SCR), die mit den genannten Detektionsmitteln (R3) gekoppelt sind zum Unterbrechen eines Treiberstromes zu der Steuerklemme des genannten Zeilenausgangstransistors (Q1), wenn der Strom in der Hauptsromstrecke einen vorbestimmten Pegel übersteigt, **dadurch gekennzeichnet, dass** die genannten Unterbrechungsmittel (SCR) einen steuerbaren Schalter umfassen, der eine Strecke zwischen der genannten ersten Hauptklemme des genannten Zeilentreibertransistors (Q2) und der genannten Steuerklemme des genannten Zeilenausgangstransistors (Q1) mit der Bezugsklemme koppelt, wobei ein Steuereingang des genannten steuerbaren Schalters (SCRs) mit den genannten Detektionsmitteln (R3) gekoppelt ist.

## Revendications

1. Circuit de déviation de ligne comprenant:
un transformateur de retour de spot (T1) ayant un enroulement primaire et un enroulement secondaire, ledit enroulement secondaire fournissant une tension anodique (Va) pour un tube à rayons cathodiques (CRT);
des moyens pour fournir une tension continue (B⁺) à une première extrémité de l'enroulement primaire dudit transformateur de retour de spot (T1);
un transistor de sortie de ligne (Q1) ayant une première borne qui est couplée à une seconde extrémité de l'enroulement primaire du transformateur de retour de spot (T1), une seconde borne principale qui est couplée à une borne de référence, et une borne de commande pour commander un courant circulant dans un trajet de courant principal qui est agencé entre la première et la seconde borne principale,
un transformateur d'attaque (T2) ayant un enroulement primaire et un enroulement secondaire, ledit enroulement secondaire ayant une première extrémité qui est couplée à la borne de commande du transistor de sortie de ligne (Q1) et une seconde extrémité qui est couplée à la seconde borne principale dudit transistor de sortie de ligne (Q1), et ledit enroulement primaire ayant une première extrémité qui est également couplée auxdits moyens de fourniture;
un transistor d'attaque de ligne (Q2) ayant une première borne principale qui est couplée à une seconde extrémité de l'enroulement primaire dudit transformateur d'attaque (T2), une seconde borne principale qui est couplée à la borne de référence et une borne de commande;
des moyens pour fournir un signal d'attaque de ligne qui est couplé à la borne de commande dudit transistor d'attaque de ligne;
des moyens de détection (R3) pour détecter le courant traversant le trajet de courant principal dudit transistor de sortie de ligne (Q1); et
des moyens d'interruption (SCR) qui sont couplés auxdits moyens de détection pour interrompre un courant d'attaque vers la borne de commande dudit transistor de sortie de ligne (Q1) lorsque le courant dans le trajet de courant principal dépasse un niveau prédéterminé,
**caractérisé en ce que** lesdits moyens d'interruption (SCR) comprennent un commutateur commandable couplant à la borne de référence un trajet entre ladite première borne principale dudit transistor d'attaque de ligne (Q2) et ladite borne de commande dudit transistor de sortie de ligne (Q1), une entrée de commande dudit commutateur commandable (SCR) étant connectée auxdits moyens de détection (R3).

2. Circuit de déviation de ligne selon la revendication 1, dans lequel lesdits moyens de détection comprennent une résistance (R3) qui est couplée entre la seconde borne principale dudit transistor de sortie de ligne (Q1) et la borne de référence.

3. Circuit de déviation de ligne selon la revendication 2, dans lequel ledit commutateur commandable (SCR) couple la première borne principale dudit transistor d'attaque de ligne (Q2) à la borne de référence.

4. Circuit de déviation de ligne selon la revendication 2, dans lequel ledit commutateur commandable (SCR) couple l'enroulement secondaire dudit transformateur d'attaque (T2) à la borne de référence.

5. Circuit de déviation de ligne selon la revendication 2, dans lequel ledit commutateur commandable (SCR) comprend un redresseur au silicium commandé (SCR).

6. Circuit de déviation de ligne selon la revendication 5, dans lequel lesdits moyens de détection comprennent une résistance (R3) qui est couplée entre la seconde borne principale dudit transistor de sortie de ligne (Q1) et la borne de référence, et une entrée de commande dudit redresseur au silicium commandé est couplée à la seconde borne principale dudit transistor de sortie de ligne (Q1).

7. Circuit de déviation de ligne selon la revendication 6, dans lequel lesdits moyens d'interruption comprennent encore une résistance (R4) connectant l'entrée de commande dudit redresseur au silicium commandé à la seconde borne principale du transistor de sortie de ligne (Q1).

8. Dispositif d'affichage comprenant:
un tube à rayons cathodiques (CRT) avec une bobine de déviation de ligne, et
un circuit de déviation de ligne comprenant:
un transformateur de retour de spot (T1) ayant un enroulement primaire et un enroulement secondaire, ledit enroulement secondaire fournissant une tension anodique (Va) pour ledit tube à rayons cathodiques;
des moyens pour fournir une tension continue (B⁺) à une première extrémité de l'enroulement primaire dudit transformateur de retour de spot (T1);
un transistor de sortie de ligne (Q1) ayant une première borne principale qui est couplée à une seconde extrémité de l'enroulement primaire du transformateur de retour de spot (T1), une seconde borne principale qui est couplée à une borne de référence, et une borne de commande pour commander un courant circulant dans un trajet de courant principal qui est agencé entre la première et la seconde borne principale,
un transformateur d'attaque (T2) ayant un enroulement primaire et un enroulement secondaire, ledit enroulement secondaire ayant une première extrémité qui est couplée à la borne de commande du transistor de sortie de ligne (Q1) et une seconde extrémité qui est couplée à la seconde borne principale dudit transistor de sortie de ligne (Q1), et ledit enroulement primaire ayant une première extrémité qui est également couplée auxdits moyens de fourniture (B⁺);
un transistor d'attaque de ligne (Q2) ayant une première borne principale qui est couplée à une seconde extrémité de l'enroulement primaire dudit transformateur d'attaque (T2), une seconde borne principale qui est couplée à la borne de référence et une borne de commande;
des moyens pour fournir un signal d'attaque de ligne qui est couplé à la borne de commande dudit transistor d'attaque de ligne (Q2);
des moyens de détection (R3) pour détecter le courant traversant le trajet de courant principal dudit transistor de sortie de ligne (Q1); et
des moyens d'interruption (SCR) qui sont couplés auxdits moyens de détection (R3) pour interrompre un courant d'attaque vers la borne de commande dudit transistor de sortie de ligne (Q1) lorsque le courant dans le trajet de courant principal dépasse un niveau prédéterminé, **caractérisé en ce que** lesdits moyens d'interruption (SCR) comprennent un commutateur commandable couplant à la borne de référence un trajet entre ladite première borne principale dudit transistor d'attaque de ligne (Q2) et ladite borne de commande dudit transistor de sortie de ligne (Q1), une entrée de commande dudit commutateur commandable (SCR) étant connectée auxdits moyens de détection (R3).
